# NEUE EUROPÄISCHE PATENTSCHRIFT

(11) **EP 1 724 925 B2**
(45) Veröffentlichungstag und Bekanntmachung des Hinweises auf die Entscheidung über den Einspruch: **28.11.2012**
(45) Hinweis auf die Patenterteilung: 20.01.2010
(21) Anmeldenummer: 06405082.6
(22) Anmeldetag: 27.02.2006
(51) Int. Cl.: H03K 17/945, G01S 15/04

(54) **Ultraschall-Näherungsschalter und Verfahren zur Erfassung strukturierter Oberflächen mittels Ultraschall**
Ultrasonic proximity switch and method for capturing surface structures with ultrasonic sound
Commutateur de proximité à ultrasons et procédé de détection d'une surface structurée à l'aide d'ondes ultrasonores

(30) Priorität: 13.05.2005 CH 8472005
(43) Veröffentlichungstag der Anmeldung: 22.11.2006
(73) Patentinhaber: Baumer Electric AG, 8500 Frauenfeld (CH)
(72) Erfinder: Mauch, Rainer, 78247 Hilzingen (DE); Nölle, Christoph, 78462 Konstanz (DE); Wehrle, Wolfgang, 78467 Konstanz (DE)
(74) Vertreter: Strauss, Steffen

(56) Entgegenhaltungen:
- EP-A- 0 997 747
- EP-A- 1 246 365
- EP-A2- 0 116 901
- DE-A1- 3 710 239
- US-A1- 2005 057 284

## Beschreibung

Gegenstand der Erfindung ist ein Ultraschall-Näherungsschalter und ein Verfahren zur Erfassung von Objekten mit strukturierten Oberflächen mittels Ultraschall gemäss den Merkmalen der Patentansprüche 1 und 6.

Ultraschall-Näherungsschalter wie z.B. in der EP 0 997 747 beschrieben arbeiten in der Regel nach dem Puls-Echo-Verfahren. Dabei emittiert ein Ultraschallwandler jeweils ein Wellenpaket bzw. einen Burst von Ultraschallwellen. Diese breiten sich entsprechend der meist keulenförmigen Richtcharakteristik des Ultraschallwandlers mit Schallgeschwindigkeit in den Raum aus. Trifft das Wellenpaket auf ein Objekt auf, werden die auf die Oberfläche des Objekts auftreffenden Schallwellen teilweise reflektiert. In der Regel breitet sich ein Teil der reflektierten Schallwellen in Richtung zum Ultraschallwandler hin aus. Dieser wirkt jetzt als Empfänger und registriert das Echosignal. Die Laufzeit, also die Zeit zwischen dem Aussenden und dem Empfangen des Bursts, ist proportional zum Abstand zwischen dem Ultraschallwandler und dem erfassten Objekt.
Da der Ultraschallwandler bzw. Transducer unmittelbar anschliessend an das Aussenden von Ultraschallwellen nachschwingt, können innerhalb eines sog. Blind- oder Totbereichs, keine Echosignale erfasst und ausgewertet werden.

Da die Dämpfung von Ultraschallwellen in Luft mit zunehmender Frequenz stark zunimmt, können mit hochfrequenten Wandlern nur noch geringe Distanzen erfasst werden.

Infolge der Temperaturabhängigkeit der Schallgeschwindigkeit können Laufzeitfehler auftreten. Diese lassen sich leicht korrigieren, indem zusätzlich die Temperatur gemessen und die Laufzeit mit einem temperaturabhängigen Korrekturfaktor multipliziert wird.

Damit ein Objekt erfasst werden kann, muss ein Teil seiner Oberfläche so ausgerichtet sein, dass mindestens ein Teil des Schalls zurück zum Transducer reflektiert wird. Ein Objekt in Gestalt einer bezüglich der Schallachse stark geneigten ebenen Platte könnte bewirken, dass der Schall weggespiegelt wird, und dass am Transducer kein Echosignal eintrifft.

Für eine sichere Erfassung eines Objekts ist nicht nur dessen Anordnung im Raum von Bedeutung, sondern auch dessen Material und dessen Oberflächenbeschaffenheit:
Bei schallharten Materialien wird der grösste Teil der auftreffenden Schallenergie reflektiert. Bei weichen Materialien hingegen, also beispielsweise bei Watte oder bei offenporigen Schaumstoffen, wird nur ein geringer Teil der Schallenergie reflektiert. Der grössere Teil durchdringt das Objekt und/oder wird im Objekt absorbiert. Weist die Oberfläche dreidimensionale Strukturen in der Grössenordnung der halben Wellenlänge oder von Vielfachen der halben Wellenlänge auf, so können durch Laufzeitunterschiede und Beugung Interferenzen entstehen, mit dem Ergebnis, dass am Empfänger kein oder nur ein schwaches Signal vorhanden ist.
Solche Situationen können beispielsweise bei der stirnseitigen Erfassung von Stapeln (insbesondere von Papier-, CD- oder Waferstapeln), bei der Erfassung rauer Oberflächen oder schaumiger Flüssigkeiten, oder bei der Erfassung von Gittern auftreten.

Eine Aufgabe der vorliegenden Erfindung ist es, einen Ultraschall-Näherungsschalter und ein Verfahren zur Erfassung von Objekten mit strukturierten Oberflächen zu schaffen.

Mit dem erfindungsgemässen Ultraschall-Näherungsschalter und dem erfindungsgemässen Erfassungsverfahren können selbst Objekte mit dreidimensionalen Oberflächenstrukturen sicher erkannt werden.

Der Näherungsschalter ist so ausgebildet, dass er Ultraschallsignale mit unterschiedlicher Frequenz aussenden und erfassen kann. Innerhalb der nutzbaren Bandbreite des Frequenzspektrums sind mehrere Frequenzen festgelegt, mit denen der Ultraschallwandler angeregt werden kann. Vorzugsweise entspricht eine dieser Frequenzen jener Frequenz, bei welcher das von einem idealen Reflektor zurückgeworfene und vom Näherungsschalter erfasste Echosignal bzw. dessen Amplitude, Dauer oder Schallenergie maximal ist.
In einer bevorzugten Ausgestaltung umfasst die Empfangs- und Auswertevorrichtung ein programmierbares bzw. veränderbares digitales oder analoges Filter, das in der Regel als Bandpassfilter ausgebildet ist. Dieses kann in Abhängigkeit der jeweiligen Sendefrequenz verändert und auf diese abgestimmt werden.
In der Erfindung wird die für einzelne Messintervalle zu verwendende Sendefrequenz in Abhängigkeit der in einem oder mehreren der vorhergehenden Messintervalle erfassten Echosignale festgelegt. Für diesen Zweck können z.B. aus früheren Messwerten abgeleitete Informationen wie die Signalspannungen oder äquivalente Grössen der letzten zehn bis zwanzig Messintervalle in einem Signalspeicher gespeichert werden. Wenn die Auswerteeinheit feststellt, dass innerhalb mehrerer der vorangegangenen Messintervalle keine Echosignale oder nur Echosignale mit ungenügender Signalhöhe erfasst wurden, wird eine fortan Frequenzalternator genannte Vorrichtung zum Ändern oder Umschalten der Sendefrequenz getriggert bzw. dazu veranlasst, dem Ultraschallwandler im nächsten Messintervall eine andere Frequenz vorzugeben.
Falls das ungenügende Signal auf die strukturierte Oberfläche des zu erfassenden Objektes zurückzuführen war, ist es wahrscheinlich, dass die strukturierte Objektoberfläche den Ultraschallburst mit geänderter Frequenz bzw. Wellenlänge nun so reflektiert, dass ein verwertbares Echosignal erfasst werden kann. Sollte das Echosignal immer noch ungenügend sein, wird in analoger Weise zur nächsten Sendefrequenz gewechselt.
Je nach Anforderungen hinsichtlich Störsicherheit und Reaktionsgeschwindigkeit kann die Auswertung der vom Empfänger erfassten Echosignale in unterschiedlicher Weise erfolgen. So kann der Ausgang des Näherungsschalters beispielsweise nur in Abhängigkeit des Messsignals aus der jeweils aktuellen Messperiode oder zusätzlich in Abhängigkeit der gespeicherten Informationen über Messsignale aus einer oder mehreren der vorangegangenen Messperioden angesteuert werden. Vorzugsweise werden Messsignale aus etwa drei bis sechs Messintervallen ausgewertet, wobei für die Durchsteuerung des Ausgangs eine Mindestanzahl erkannter Echosignale erforderlich ist. Auf diese Weise kann verhindert werden, dass ein einzelnes ungenügendes Echosignal, welches infolge der Umschaltung zu einer anderen Sendefrequenz entstanden ist, zu einer ungewollten Zustandsänderung am Ausgang des Näherungsschalters führen könnte.

Ultraschallwandler umfassen in der Regel eine Piezokeramikscheibe, die auf eine akustische Anpassschicht mit geringerer akustischer Impedanz aufgeklebt ist, eine Dämpfmasse und ein Wandlergehäuse. Diese Komponenten sind so aufeinander abgestimmt und miteinander verbunden, dass der Wandler eine ausgeprägte Resonanzfrequenz aufweist, bei welcher der Wirkungsgrad bzw. die vom Wandler emittierbare Schalleistung maximal ist. Die nutzbare Bandbreite eines Wandlers wird wesentlich durch die Dämpfmasse und durch die Art der Verbindungen der einzelnen Wandlerkomponenten miteinander beeinflusst. Gewisse Ultraschallwandler können zusätzlich zur Hauptresonanzfrequenz eine oder mehrere weitere Nebenresonanzen aufweisen. Der Frequenzgang von Ultraschallwandlern kann zudem temperaturabhängig sein.

Die Ansteuerung eines Ultraschallwandlers mit unterschiedlichen Frequenzen bewirkt einerseits die Emission von Ultraschallwellen mit unterschiedlichen Wellenlängen. Andererseits können auch andere Parameter wie z.B. das Ausschwingverhalten, die Richtcharakteristik einschliesslich allfälliger Nebenkeulen und der Wirkungsgrad von der Frequenz abhängen. Es ist deshalb sinnvoll, für jeden Wandlertyp einen oder mehrere Frequenzbereiche zu ermitteln, die für den Betrieb des Wandlers geeignet sind.
Die Möglichkeit zum Wechseln der Sendefrequenz kann z.B. auch dazu benutzt werden, Objekte ausserhalb des festgelegten Erfassungsbereichs zu detektieren, also beispielsweise innerhalb eines Teils des Blindbereichs. Im Weiteren ist das Verfahren nicht nur bei Näherungsschaltern, sondern auch bei Ultraschall-Distanzmessgeräten einsetzbar.

Anhand einiger Figuren wird die Erfindung im Folgenden näher beschrieben. Dabei zeigen
- Figur 1: eine schematische Darstellung der Erfassung eines Papierstapels mit einem Ultraschall-Näherungsschalter bei unterschiedlichen Sendefrequenzen,
- Figur 2: einen Frequenzgang eines ersten Transducers,
- Figur 3: einen Frequenzgang eines zweiten Transducers,
- Figur 4: ein Blockschema eines Ultraschall-Näherungsschalters.

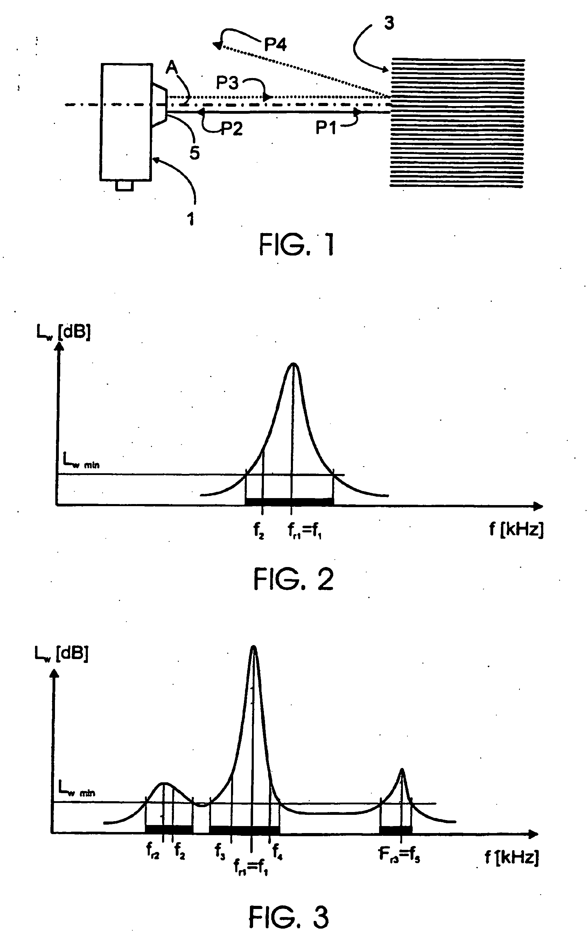

Figur 1 zeigt schematisch einen Ultraschall-Näherungsschalter 1 bei der Erfassung eines Objektes 3. Im vorliegenden Beispiel ist das Objekt 3 ein Papierstapel. Ein Ultraschallwandler, auch kurz Wandler 5 oder Transducer genannt, emittiert periodisch Ultraschallbursts mit einer ersten Sendefrequenz f1. Der Wandler 5 hat u.a. bei dieser Frequenz f1 eine ausgeprägte Richtcharakteristik: Die Schallwellen breiten sich innerhalb eines schmalen Öffnungswinkels von z.B. etwa 15° in Richtung der akustischen Achse A aus. Sie treffen seitlich auf eine Stirnseite des Papierstapels auf und werden an dieser grösstenteils reflektiert. Diese seitliche Oberfläche bzw. Stirnseite des Papierstapels hat eine periodische Struktur, welche durch die Dicke der einzelnen Blätter bestimmt ist. Zusätzlich kann die Stirnseite eine überlagerte dreidimensionale Struktur aufweisen, welche dadurch zustande kommt, dass die einzelnen Blattkanten nicht exakt deckungsgleich übereinander liegen, sondern teilweise in einer oder zwei Dimensionen leicht versetzt und/oder verdreht zueinander angeordnet sind. Diese Struktur kann zufällig oder periodisch sein. Der Papierstapel ist so ausgerichtet, dass die dem Wandler 5 zugewandte Stirnseite ungefähr vertikal zur akustischen Achse A steht. Trifft nun ein Schallwellenpaket der Frequenz f1 auf die Stirnseite des Objekts 3 auf, wird es zurück zum Wandler 5 reflektiert. Dies ist in Figur 1 durch die ausgezogene Linie mit den Pfeilen P1 und P2 dargestellt. Bei einer anderen Sendefrequenz f2 kann es sein, dass nur noch ein unzureichend kleiner Teil des Schalls zum Wandler 5 zurück reflektiert wird.
Dies kann darauf zurückzuführen sein, dass aufgrund der dreidimensionalen Oberflächenstruktur des Papierstapels 3 und sich daraus ergebender Laufzeitunterschiede Interferenzen entstehen. Dies ist insbesondere dann der Fall, wenn die halbe Wellenlänge λ/2 des Schalls bei der Sendefrequenz f2 eine ähnliche Grössenordnung hat, wie die Oberflächenstruktur. Solche Interferenzen können dazu führen, dass das reflektierte Signal nur noch eine kleine Amplitude am Empfänger zeigt. In Figur 1 zeigt die unterbrochene Linie mit den Pfeilen P3 und P4 symbolisch die im Vergleich zu einer glatten Objektoberfläche unterschiedlichen Reflexionseigenschaften einer strukturierten Objektoberfläche.
Die Figuren 2 und 3 zeigen je ein Diagramm mit den Frequenzgängen zweier verschiedener Wandler 5. Dabei ist jeweils auf der Ordinate der Schalleistungspegel L_{w} bezüglich einer genormten Bezugsschallleistung p₀ angegeben, und auf der Abszisse die Frequenz f in Kiloherz. Zur sicheren Erfassung von Objekten ist ein (experimentell zu bestimmender) minimaler Schallleistungspegel L_{wmin} erforderlich. Die Balken auf der Abszisse markieren die - aufgrund des erreichbaren Schallleistungspegels L_{w} und der Empfangsempfindlichkeit des Wandlers 5 - nutzbaren Frequenzbereiche des Näherungsschalters 1. Im Beispiel von Figur 2 hat der Wandler 5 nur eine Resonanz mit der Resonanzfrequenz fᵣ₁. Im Beispiel von Figur 3 ist eine Hauptresonanz fᵣ₁ und zwei Nebenresonanzen fᵣ₂ und fᵣ₃ erkennbar. Innerhalb dieser Frequenzbereiche werden mindestens zwei, vorzugsweise drei oder mehr unterschiedliche Arbeitsfrequenzen fᵢ, wobei der Index i eine natürliche Zahl ist, bestimmt. Vorzugsweise ist mindestens eine der Arbeitsfrequenzen fᵢ gleich einer der Resonanzfrequenzen frⱼ, wobei der Index j wiederum eine natürliche Zahl ist. Die Hauptresonanzfrequenz fr₁ eines Wandlers 5 ist in der Regel grösser als etwa 40kHz und kleiner als etwa 800kHz. Für einen Nahbereichs-Näherungsschalter 1 kann die Resonanzfrequenz fr₁ z.B. bei etwa 300kHz liegen und die Bandbreite etwa +/- 50kHz betragen. Dies entspricht bei einer Schallgeschwindigkeit von 340m/s ungefähr einem Wellenlängenbereich von 1.36mm bis 0.97mm.

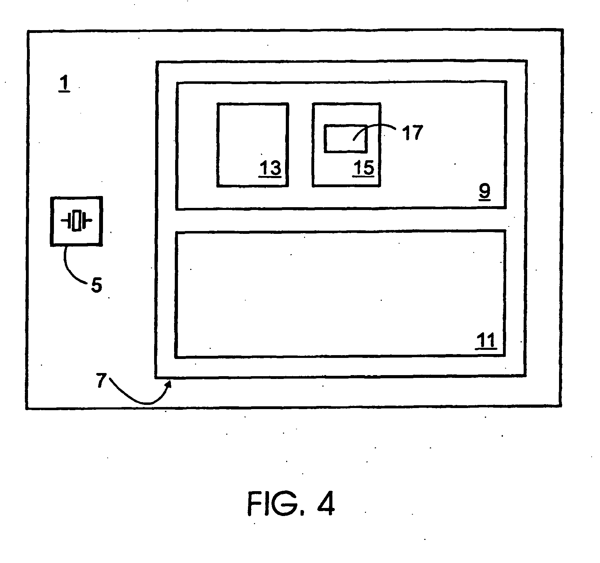

Figur 4 zeigt ein vereinfachtes Blockschaltbild eines Ultraschall-Näherungsschalters 1 mit dem Wandler 5 und einer elektronischen Steuerung 7. Die Steuerung 7 umfasst eine Sendevorrichtung 9 und eine Empfangs- und Auswertevorrichtung 11. Die Sendevorrichtung 9 umfasst einen Frequenzgenerator 13 und einem Frequenzalternator 15. Diese können z.B. mittels eines entsprechend programmierten und beschalteten Microcontrollers (nicht dargestellt) der Steuerung 7 realisiert werden. Der Frequenzalternator 15 umfasst einen Speicher 17 zum Speichern von Werten geeigneter Arbeitsfrequenzen fᵢ oder äquivalenter Werte, die dem Frequenzgenerator 13 als Steuergrössen zum Erzeugen der jeweiligen Arbeitsfrequenz fᵢ vorgegeben werden. Im Speicher 17 können vorzugsweise für jede der Arbeitsfrequenzen fᵢ zugeordnete weitere Parameter gespeichert werden wie z.B. Werte zur Charakterisierung des jeweiligen Schalleistungspegels L_{wi} und/oder des optimalen Tastverhältnisses und/oder der geeigneten Anzahl Pulse eines Pulspakets und/oder der Ausschwingdauer des Wandlers 5. Alternativ können auch Algorithmen bzw. Vorschriften zur Berechnung von Arbeitsfrequenzen im Speicher 17 gespeichert werden. Im Weiteren sind im Frequenzalternator 15 Vorschriften bzw. Kriterien für die Parametrisierung des Frequenzgenerators 13 vorgegeben. So können z.B. eine feste Reihenfolge der Arbeitsfrequenzen fᵢ und/oder eine Anzahl Messintervalle, nach der ein Wechsel zur nächsten Arbeitsfrequenz fⱼ vorgesehen ist, vorgegeben werden. Die Wahl der aktuellen Arbeitsfrequenz fᵢ bzw. der Wechsel zur nächsten Arbeitsfrequenz wird nicht fest vorgegeben, sondern in Abhängigkeit der jeweils von der Empfangs- und Auswertevorrichtung 11 erfassten und ausgewerteten Echosignale berechnet. Damit bei dieser Berechnung Echosignale aus mehreren vorangehenden Messintervallen berücksichtigt werden können, kann ein Signalspeicher zum Speichern von Kennwerten für oder von Echosignalen wie z.B. Vergleichswerte und/oder Messwerte für Echoamplitude, Echodauer oder Echolaufzeit vorgesehen sein.
Nachfolgend ist ein möglicher Ablauf zum Ansteuern des Wandlers 5 mit unterschiedlichen Frequenzen beschrieben:

Solange die Empfangs- und Erfassungseinheit 11 kein Echosignal feststellen kann, ist ein Frequenzsuchlauf aktiviert. Dabei wechselt der Frequenzalternator 15 - vorzugsweise beginnend mit der Hauptresonanzfrequenz fᵣ₁ - entsprechend einer vorgegebenen zyklischen Reihenfolge nach jedem Messintervall zur nächstfolgenden Sendefrequenz fᵢ. Sobald ein Echosignal erfasst wird, wird die zugehörige Sendefrequenz fᵢ für die nachfolgenden z.B. 10 Intervalle beibehalten. Wenn innerhalb dieser 10 Intervalle ein Echo ausbleibt, wird sofort wieder zum ursprünglichen Frequenzsuchlauf umgeschaltet. Sobald 10 aufeinander folgende Echos erfasst worden sind, wird eine Frequenzoptimierung durchgeführt. Dabei wird jeweils für eine Messperiode entsprechend der vorgegebenen Reihenfolge ein Sendesignal mit einer anderen Frequenz fᵢ erzeugt. Ist das zugehörige Echo stärker als die zuvor erfassten Echos (dies kann z.B. anhand der Breite bzw. der Dauer des verstärkten, gleichgerichteten und gefilterten Echosignals festgestellt werden), wird die zugehörige Sendefrequenz fᵢ als neue optimale Sendefrequenz fᵢ bestimmt. Der Frequenzoptimierungsprozess wird fortgesetzt, bis alle verfügbaren Frequenzen fᵢ getestet worden sind. Falls nach einem Frequenzwechsel das zugehörige Echosignal ungenügend klein ist oder nicht mehr erfasst werden kann, wird sofort wieder zur vorherigen Sendefrequenz fᵢ mit dem stärksten Echosignal umgeschaltet. Sobald wieder 10 aufeinander folgende Echos erfasst worden sind, wird der Frequenzoptimierungsprozess mit den restlichen Frequenzen fᵢ fortgesetzt. Nachdem die optimale Frequenz fᵢ bestimmt worden ist, wird diese solange beibehalten, bis z.B. in 3 aufeinander folgenden Messintervallen ein deutlich schwächeres Echosignal festgestellt werden kann. In diesem Fall erfolgt wieder eine Umschaltung in den Frequenzoptimierungsprozess.

Die hier beschriebene beispielhafte Lösung dient dem besseren Verständnis der Erfindung und bezweckt nicht eine Einschränkung des Schutzbereichs.

Bei Empfangs- und Auswertevorrichtungen können analoge und/oder digitale Filter vorgesehen sein, beispielsweise Bandpassfilter, welche auf die jeweilige Sendefrequenz fᵢ abgestimmt sind. Selbstverständlich können auch diese Filter auf die jeweiligen aktiven Sendefrequenzen abgestimmt werden.
Im Weiteren wird darauf hingewiesen, dass anstelle eines gemeinsamen Wandlers 5 zum Senden und Empfangen der Ultraschallsignale auch zwei unabhängige Wandler 5 verwendet werden können.
Die Erfindung beschränkt sich nicht nur auf Ultraschall-Näherungsschalter 1, bei denen die Anwesenheit eines Objektes innerhalb eines vorgebbaren Schaltabstandes bzw. innerhalb eines vorgebbaren Erfassungsbereichs erkannt wird, sondern auch auf Ultraschall-Distanzsensoren bzw. Ultraschall-Näherungssensoren, bei denen aus der Laufzeit des Echosignals ein analoges oder digitales Abstandsignal berechnet und ausgegeben wird.

## Patentansprüche

1. Ultraschall-Näherungssensor mit mindestens einem Ultraschallwandler (5) und einer elektronischen Steuerung (7), wobei diese Steuerung (7) eine Sendevorrichtung (9) mit einem Frequenzgenerator (13) umfasst, die zum Ansteuern des Ultraschallwandlers (5) in aufeinander folgenden Messintervallen mit Sendesignalen ausgebildet ist und eine zum Empfangen und Auswerten von Echosignalen ausgebildete Empfangs- und Auswertevorrichtung (11) umfasst,
**dadurch gekennzeichnet, dass**
die Frequenz der Sendesignale für jedes der Messintervalle von einem Frequenzalternator (15) als eine von mehreren Arbeitsfrequenzen vorgebbar ist,
wobei im Frequenzalternator (15) Vorschriften für die Parametrisierung des Frequenzgenerators (13) vorgebbar sind,
wobei eine Wahl der aktuellen Arbeitsfrequenz und ein Wechsel zur nächsten Arbeitsfrequenz in Abhängigkeit der in einem oder mehreren der vorhergehenden Messintervalle erfassten Echosignale festlegbar ist.

2. Ultraschall-Näherungssensor nach Anspruch 1, **dadurch gekennzeichnet, dass** der Frequensalternator (15) einen Speicher (17) zum Speichern mehrerer unterschiedlicher·Sendefrequenzen oder zum Speichern von Vorschriften bzw. Algorithmen für die Berechnung solcher unterschiedlicher Sendefrequenzen umfasst.

3. Ultraschall-Näherungssensor nach Anspruch 2, **dadurch gekennzeichnet, dass** im Speicher (17) zu jeder gespeicherten Sendefrequenz zugehörige weitere Parameter speicherbar sind.

4. Ultraschall-Näherungssensor nach einem der vorhergehenden Ansprüche, wobei die Empfangs- und Auswertevorrichtung (11) ein veränderbares Filter umfasst, **dadurch gekennzeichnet, dass** die Filtereigenschaften in Abhängigkeit der jeweiligen durch den Frequenzalternator (15) vorgegebenen Sendefrequenz veränderbar sind.

5. Verfahren zur Erfassung strukturierter Oberflächen von Objekten mit den folgenden Verfahrensschritten:
- von einem Ultraschallwandler (5) werden in aufeinander folgenden Messintervallen Ultraschallsignale emittiert,
- von den Objekten (3) reflektierte Echos dieser Ultraschallsignale werden erfasst und ausgewertet,
- die Frequenz der Sendesignale wird für jedes der Messintervalle von einem Frequenzalternator (15) als eine von mehreren Arbeitsfrequenzen innerhalb des nutzbaren Frequenzspektrums des Ultraschallwandlers (5) vorgegeben,
- wobei im Frequenzalternator (15) Vorschriften für die Parametrisierung des Frequenzgenerators (13) vorgegeben sind,
- wobei eine Wahl der aktuellen Arbeitsfrequenz und der Wechsel zur nächsten Arbeitsfrequenz in Abhängigkeit der in einem oder mehreren der vorhergehenden Messintervalle erfassten Echosignale festgelegt wird.

6. Verfahren nach Anspruch 5, **dadurch gekennzeichnet, dass** innerhalb des Frequenzspektrums des Wandlers (5) mehrere Arbeitsfrequenzen festgelegt werden, und dass die Umschaltung der Sendefrequenz zwischen diesen Arbeitsfrequenzen in Abhängigkeit der Stärke der Echosignale erfolgt.

7. Verfahren nach Anspruch 6, **dadurch gekennzeichnet, dass** Informationen über die Stärke der Echosignale gespeichert werden, und dass diese gespeicherten Informationen für die Ermittlung der geeigneten Sendefrequenz benutzt werden.

8. Verfahren nach einem der Ansprüche 5 bis 7, wobei die erfassten Ultraschallsignale von einem veränderbaren Filter gefiltert werden, **dadurch gekennzeichnet, dass** die Filtereigenschaften in Abhängigkeit der Sendefrequenz verändert werden.

## Claims

1. Ultrasonic proximity sensor with at least one ultrasonic transducer (5) and with an electronic control (7), whereby this control (7) comprises an transmitting device (9) with a frequency generator (13), which is designed to activate the ultrasonic transducer (5) in consecutive measurement intervals with transmission signals, and whereby this control (7) comprises a receiving and evaluation device (11) designed to receive and evaluating echo signals, **characterized in that** the frequency of the transmission signals can be set by a frequency alternator (15) as one of several operating frequencies for each of the measuring intervals, whereby specifications for the parameterization of the frequency generator (13) can be set in the frequency alternator (15), whereby selection of the current operating frequency and switch-over to the next operating frequency can be defined depending on the echo signals acquired in one or several of the preceding measuring intervals.

2. An ultrasound proximity sensor according to claim 1, **characterised in that** the frequency alternator (15) comprises a memory (17) for storing several different operating frequencies fᵢ or for storing rules or algorithms for the computation of such different operating frequencies fᵢ.

3. An ultrasound proximity sensor according to claim 2, **characterised in that** further parameters belonging to each stored transmission frequency may be stored in the memory (17).

4. An ultrasound proximity sensor according to one of the claims 1 to 3, wherein the receiver and evaluation device (11) comprises a changeable filter, **characterised in that** the filter characteristics may be changed in dependence on the respective transmission frequency set by the frequency alternator (15).

5. Process for detecting structured surfaces of objects with the following process steps:
- ultrasonic signals are transmitted by an ultrasonic transducer (5) at consecutive measuring intervals,
- echoes of these ultrasonic signals reflected by the objects (3) are detected and evaluated,
- the frequency of the transmitted signals is set by a frequency alternator (15) as one of several operating frequencies within the usable frequency spectrum of the ultrasonic transducer (5) for each of the measuring intervals,
- whereby specifications for the parameterization of the frequency generator (13) are set in the frequency alternator (15),
- whereby selection of the current operating frequency and switch-over to the next operating frequency is defined depending on the echo signals acquired in one or several of the preceding measuring intervals.

6. A method according to claim 5, **characterised in that** several working frequencies are fixed within the frequency spectrum of the transducer (5), and that the switch-over of the transmission frequency between these operating frequencies is effected in dependence on the strength of those echo signals.

7. A method according to claim 6, **characterised in that** information on the strength of those echo signals is stored and that this stored information is used for determining the suitable transmission frequency.

8. A method according to one of the claims 5 to 7, wherein the detected ultrasound signals are filtered by a changeable filter, **characterised in that** the filter characteristics are changed in dependence on the transmission frequency.

## Revendications

1. Détecteur de proximité à ultrasons doté d'au moins un transducteur ultrasonore (5) et d'une commande électronique (7), cette commande (7) comprenant un dispositif émetteur (9) avec un générateur de fréquence (13) qui est conçu pour exciter le transducteur ultrasonore (5) à des intervalles de mesure successifs avec des signaux émetteurs et comprenant un dispositif récepteur et évaluateur (11) conçu pour recevoir et évaluer les signaux de l'écho, **caractérisé en ce que** la fréquence des signaux émetteurs peut être prédéfinie pour chacun des intervalles de mesure par un alternateur de fréquence (15) comme une fréquence de travail parmi plusieurs, dans l'alternateur de fréquence (15) des prescriptions pouvant être prédéfinies pour le paramétrage de l'alternateur de fréquence (13), une sélection de la fréquence de travail actuelle et un passage à la prochaine fréquence de travail pouvant être définis en fonction des signaux de l'écho détectés dans un ou plusieurs des intervalles de mesure précédents.

2. Détecteur de proximité à ultrasons, selon la revendication 1, **caractérisé en ce que** l'alternateur de fréquences (15) comprend une mémoire (17) pour stocker plusieurs fréquences de travail fᵢ différentes ou pour stocker des instructions ou des algorithmes pour le calcul de telles fréquences de travail fᵢ différentes.

3. Détecteur de proximité à ultrasons, selon la revendication 2, **caractérisé en ce que** d'autres paramètres correspondant à chaque fréquence d'émission stockée peuvent être stockés dans la mémoire (17).

4. Détecteur de proximité à ultrasons, selon une des revendications 1 à 3, dans lequel le dispositif de réception et d'évaluation (11) comprend un filtre variable, **caractérisé en ce que** les propriétés du filtre sont variables en fonction de la fréquence d'émission respective prédéfinie par l'alternateur de fréquences (15).

5. Procédé permettant de détecter des surfaces structurées d'objets comprenant les étapes suivantes :
- des signaux ultrasonores sont émis par un transducteur ultrasonore (5) à des intervalles de mesure successifs,
- les échos de ces signaux ultrasonores réfléchis par les objets (3) sont détectés et évalués,
- la fréquence des signaux émetteurs est prédéfinie pour chacun des intervalles de mesure par un alternateur de fréquence (15) comme une fréquence de travail parmi plusieurs au sein du spectre de fréquence utile du transducteur ultrasonore (5),
- dans l'alternateur de fréquence (15), des prescriptions étant prédéfinies pour le paramétrage du générateur de fréquence (13),
- une sélection de la fréquence de travail actuelle et un passage à la prochaine fréquence de travail pouvant être définis en fonction des signaux de l'écho détectés dans un ou plusieurs des intervalles de mesure précédents.

6. Procédé selon la revendication 5, **caractérisé en ce que** plusieurs fréquences de travail sont définies à l'intérieur du spectre de fréquences du transducteur (5), et que la commutation de la fréquence d'émission entre ces fréquences de travail a lieu en fonction de l'intensité des signaux d'écho.

7. Procédé selon la revendication 6, **caractérisé en ce que** des informations sur l'intensité des signaux d'écho sont stockées, et que ces informations stockées sont utilisées pour la détermination de la fréquence d'émission appropriée.

8. Procédé selon une des revendications 5 à 7, dans lequel les signaux ultrasonores détectés sont filtrés par un filtre variable, **caractérisé en ce que** les propriétés du filtre sont variables en fonction de la fréquence d'émission.
